Europäisches Patentamt

European Patent Office

Office européen des brevets

(11) Publication number: **0 102 525**
**B1**

# (12) EUROPEAN PATENT SPECIFICATION

(45) Date of publication of patent specification: **06.07.88**

(51) Int. Cl.⁴: **H 01 L 23/54, H 01 L 21/60**

(21) Application number: **83107585.8**

(22) Date of filing: **02.08.83**

(54) **Alpha-particle protection in integrated circuit packages.**

(30) Priority: **23.08.82 US 410624**

(43) Date of publication of application:
**14.03.84 Bulletin 84/11**

(45) Publication of the grant of the patent:
**06.07.88 Bulletin 88/27**

(84) Designated Contracting States:
**BE DE FR GB NL SE**

(56) References cited:
**EP-A-0 045 561**
**EP-A-0 070 242**
**FR-A-2 311 406**

(73) Proprietor: **BURROUGHS CORPORATION (a Delaware corporation).**
**Burroughs Place**
**Detroit Michigan 48232 (US)**

(72) Inventor: **Firth, Horace Allen**
**1028 Hazen Drive**
**San Marcos California 92069 (US)**

(74) Representative: **Eisenführ & Speiser**
**Martinistrasse 24**
**D-2800 Bremen 1 (DE)**

Courier Press, Leamington Spa, England.

## Description

Background of the Invention

This invention relates to a structure for use in the fabrication of integrated circuits of the type that protect the circuit from alpha-particle radiation.

Alpha particles are positively charged nuclear particles that are ejected at high speeds by the decay of various radioactive elements, such as uranium or thorium. These radioactive elements are present in very small trace quantities in nearly all materials including those used in integrated circuit packages. Consequently, unless protective steps are taken, the alpha particles will collide with atoms in the integrated circuit to there produce electron-hole pairs. Then if the circuit includes charge-sensitive circuitry, such as a dynamic MOS memory cell, the electron-hole pairs will cause the circuit to malfunction.

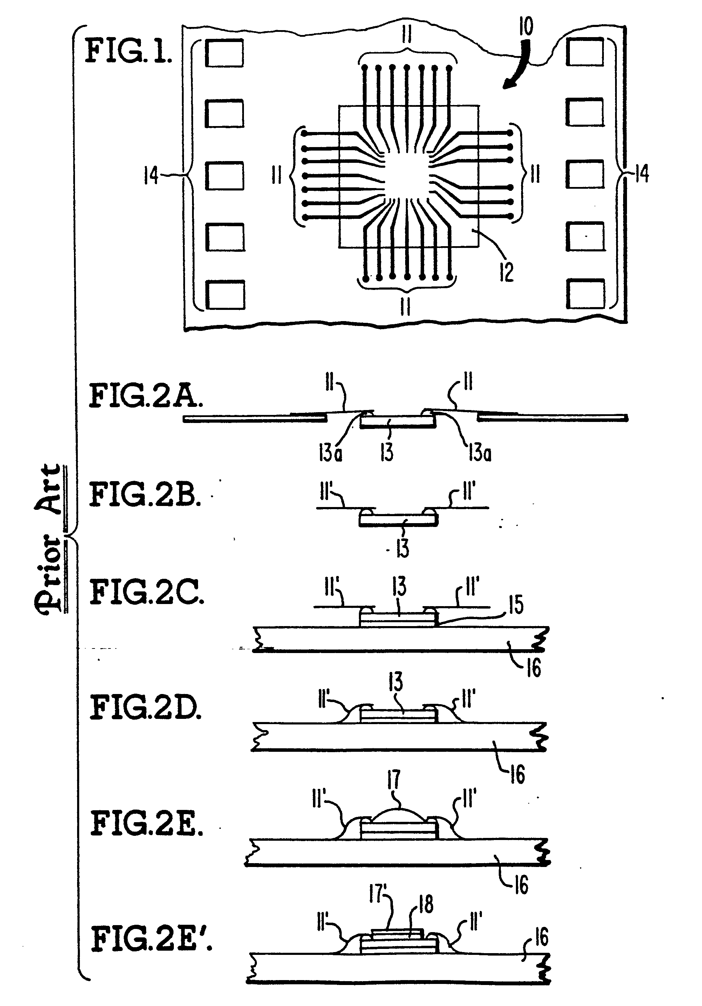

In the prior art, a polyimide shield has been applied over the integrated circuit chip to block the alpha particles from the circuit. See, for example, *Electronic Design*, November 22, 1980, pp. 36—37 wherein two such shields are described. In general, one shield is formed by depositing liquid polyimide over the surface of the integrated circuit chip and thereafter curing the polyimide; while the other shield is formed by attaching a solid film of polyimide via an adhesive to the surface of the integrated circuit chip. Both prior art methods are illustrated herein via Figures 1 and Figures 2A—2E'.

To begin, as illustrated in Figure 1, a 35 millimeter polyimide tape 10 is provided which has a plurality of electrical conductors 11 disposed thereon. Tape 10 also has a centrally located hole 12; and the conductors 11 extend from the tape in a cantilevered fashion into hole 12. Conductors 11 have their ends arranged in hole 12 such that they align with bumped bonding terminals 13a on the integrated circuit chip 13. The number of electrical conductors 11 and their dimensions vary depending upon the particular chip 13 to which they are to be bonded. Additional sets of conductors 11 and holes 12 are repeated along other portions of tape 10 (not shown); and sprocket holes 14 are provided along the edges of tape 10 so that each set of conductors 11 can be positioned over a chip automatically.

After the conductors 11 have been positioned over terminals 13a of chip 13, they are bonded to the terminals 13a by heating their ends to approximately 400°C. This step is illustrated in Figure 2A. Thereafter, conductors 11' are excised from tape 10 by a punch which cuts the conductors 11 around the outside perimeter of hole 12. This step is illustrated in Figure 2B. Subsequently, chip 13 is attached via an adhesive 15 to a substrate 16. This step is illustrated in Figure 2C. Thereafter, another bonding step is performed which connects the excised ends of the conductors 11' to other conductors on substrate 16. This step is illustrated in Figure 2D.

Later, additional steps are performed to attach the alpha-particle shield to chip 13. As illustrated in Figure 2E, these steps include the application of several drops of liquid polyimide 17 onto chip 13, and thereafter allowing the liquid to cure. Alternatively, as illustrated in Figure 2E', these steps include the attaching of a solid polyimide film 17' via an adhesive 18 to chip 13.

A problem, however, wiht applying liquid polyimide to chip 13 to form the protective shield is that the thickness of the shield is not uniform over the chip's surface. Instead, the shield is much thinner at its perimeter than at its center; and thus, the perimeter of the shield is susceptible to penetration by alpha particles. Also, the thickness of the shield's perimeter cannot be increased simply by applying more polyimide in liquid form to the chip because if the liquid touches the conductors 11', it has a tendency to break those conductors off of the terminals 13a when it cures and hardens.

Further, a problem with the method of forming the alpha particle shield by attaching the solid polyimide film 17' via an adhesive as illustrated in Figure 2E' is that the alignment of the polyimide film over chip 13 is a very delicate operation. If the film 17' is forced against the conductors 11', it can cause them to break off of the terminals 13a. Consequently, the attaching steps must be performed by hand or by machinery that aligns the film 17' between the terminals 13a very accurately; but this adds to the cost of the package. Also, since the adhesive lies directly on the integrated circuit, it must be highly purified to insure that it doesn't contain any contaminants, such as CL− and NA+, which would migrate from the adhesive into the integrated circuit and cause a malfunction. In addition, the adhesive 18 and the piece of polyimide film 17' are extra materials which further increase the cost of the package.

Brief Summary of the Invention

Accordingly, one object of the invention is to provide an improved structure for use in fabricating integrated circuits of the type that protect the circuit from alpha-particle radiation.

Another object of the invention is to provide a structure for use in fabricating integrated circuits such that the fabrication process consists of a reduced number of fabrication steps.

Still another object of the invention is to provide a structure for use in fabricating integrated circuits such that the fabrication process uses a reduced amount of materials.

These and other objects are achieved by providing a film of material having a hole which surrounds a central portion of the film and separates it from the remaining film portion. The central film portion includes a body with arms extending therefrom. A plurality of electrical conductors are disposed on the remaining film portion; and those conductors extend from the remaining film portion across the hole onto the arms of the central film portion to hold it in place. From the arms, the conductors further extend in a cantilevered fashion into the hole towards the body of the central film portion. The body portion of the film is shaped to cover a part of the integrated circuit and thereby shield it from alpha particles, while the cantilevered conductors are arranged such that their ends align with contact pads in the integrated circuit outside of the covered portion.

In another embodiment of the invention, a film of material is provided having a plurality of holes which are arranged to surround a central portion of the film and separate that central portion from the remaining film portion except for arms of the control portion which extend between the holes. A plurality of electrical conductors are disposed on the remaining film portion; and they extend therefrom in a cantilevered fashion into the holes towards the central film portion. At least some of the conductors attach to the arms of the central film portion. The central film portion is shaped to cover a part of an integrated circuit and thereby shield it from alpha particles, and the ends of the cantilevered conductors are shaped to align with contact pads in the circuit outside of the covered part.

Brief Description of the Drawings

Various features and advantages of the invention are described herein in the Detailed Description in conjunction with the accompanying drawings wherein:

·Figure 1 is a plan view of a prior art structure for use in fabricating integrated circuits of the prior art;

Figures 2A—2E' illustrate the prior art steps by which the structure of Figure 1 is utilized to fabricate integrated circuits;

Figure 3 is a plan view of a structure for use in fabricating integrated circuits, which structure constitutes an embodiment of the present invention;

Figures 4A—4D illustrate the steps by which the structure of Figure 3 is utilized to fabricate integrated circuits;

Figure 5 is a plan view of another embodiment of the invention;

Figure 6 is a plan view of still another embodiment of the invention; and

Figure 7 is a plan view of yet another embodiment of the invention.

Detailed Description of the Invention

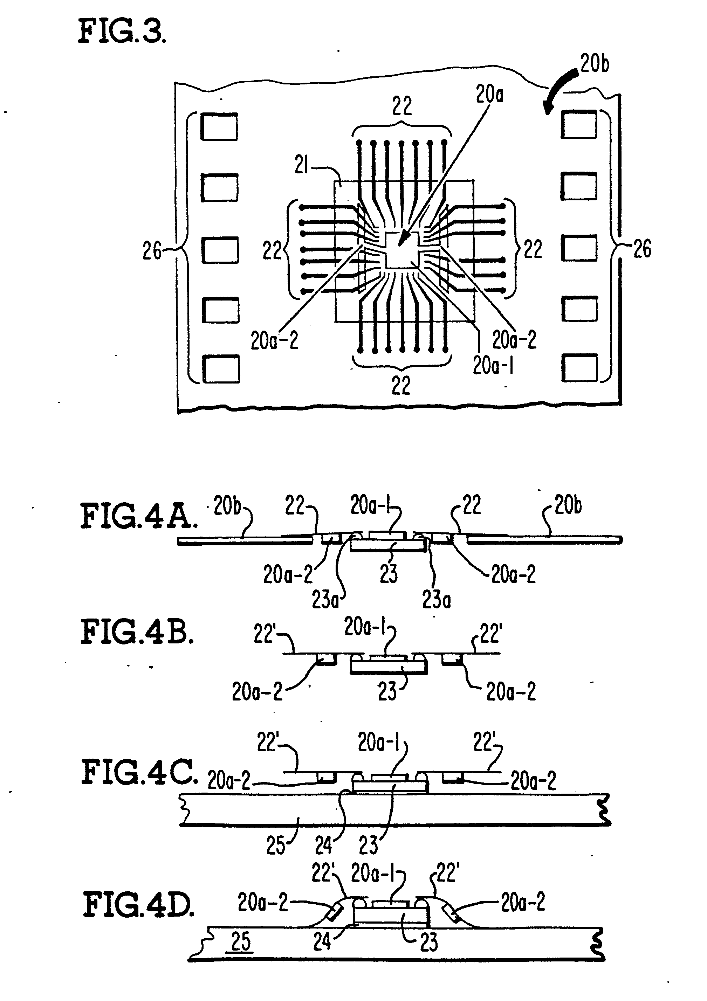

Referring now to Figures 3 and 4A—4D, a preferred embodiment of the invention along with a method of attaching the same to an integrated circuit chip will be described. This embodiment of the invention includes a film of polyimide 20 having a hole 21 which surrounds a central portion 20a of the film and separates it from the remaining film portion 20b. Film portion 20a includes a rectangular-shaped body 20a—1 and a pair of T-shaped arms 20a—2 that extend from the body. A plurality of electrical conductors 22 are disposed on film portion 20b; and they extend therefrom across hole 21 onto the arms 20a—2 of film portion 20a to hold it in place. From there, the conductors 22 further extend off of the arms 20a—2 in a cantilevered fashion into hole 21 towards the body 20a—1 of film portion 20a.

Body 20a—1 is shaped to cover a part of an integrated circuit chip 23 and thereby shield it from alpha particles; and the ends of the cantilevered conductors 22 are shaped to align with terminals 23a on chip 23 which lie outside of the covered part. Figure 4A illustrates the step in which the conductors 22 are attached to the terminals 23a. During that step, all of the conductors are attached to respective terminals at the same time by a "gang" bond; or alternatively, the conductors are attached one at a time to respective terminals by a "woodpecker" bond. In either case, after the bonding step is complete, body 20a—1 of film portion 20a overlies chip 23 and it is held in place by arms 20a—2.

Subsequently, as illustrated in Figure 4B, conductors 22' are excised from film portion 20b by cutting or punching the conductors 22 around the outer perimeter of hole 21. Thereafter, as illustrated in Figure 4C, chip 23 is attached via an adhesive 24 to a substrate 25. Later, as illustrated in Figure 4D, the outer ends of the excised conductors 22' are bonded to corresponding conductors on the substrate.

An attractive feature of the above-described embodiment of the invention is that it substantively reduces the number of steps that are needed to fabricate an integrated circuit in comparison to the prior art. This is evident by comparing the process steps of Figures 4A—4D with the corresponding prior art process steps of Figures 2A—2E'. Such a comparison shows that the extra prior art process steps of Figures 2E and 2E' which attach the alpha-particle shield are eliminated. Also, the cost which those extra steps inherently add to the integrated circuit due to their use of extra materials, extra labor, and extra tools to apply the materials is eliminated.

Preferably, the Figure 3 embodiment is fabricated by a double-etching process. To begin a film of polyimide having a film of copper on one surface thereof is provided. Suitably, this is achieved by casting a polyimide film onto a copper foil; or alternatively it is achieved by depositing copper onto a polyimide film. Thereafter, photoresist is deposited on the copper; the resist is patterned to cover only the conductors 22; and the exposed copper is etched completely through so that only the conductors 22 and the polyimide film remain. Later, another layer of photoresist is deposited on the polyimide; that resist is patterned to cover only polyimide portions 20a and 20b; and the exposed polyimide is etched completely through to form hole 21 along with sprocket holes 26.

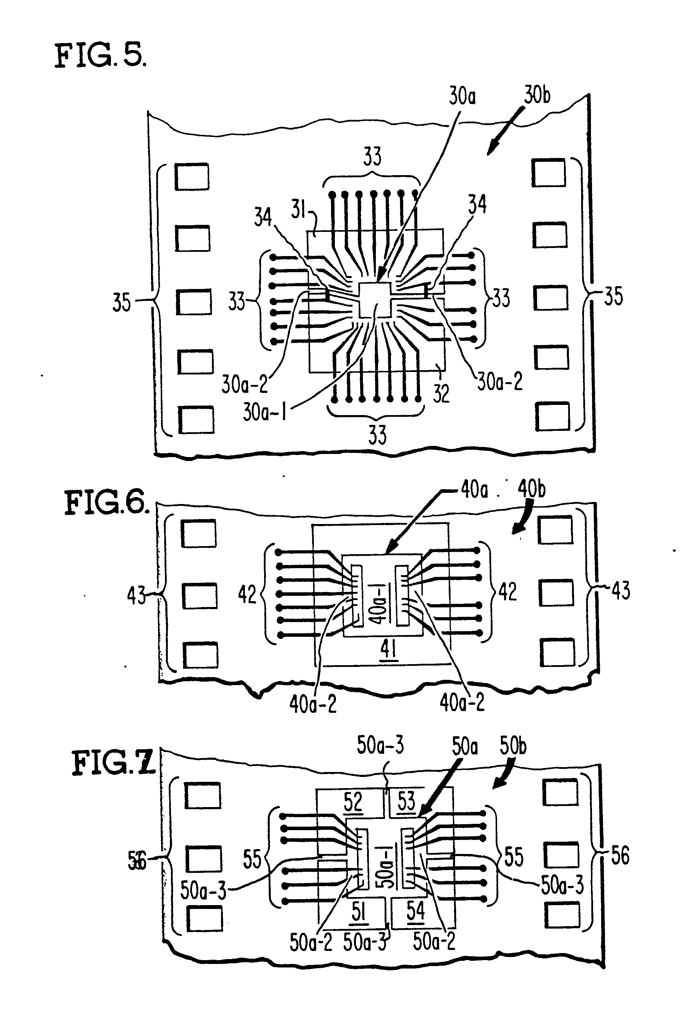

Next, with reference to Figure 5, another preferred embodiment of the invention will be described in detail. This embodiment includes a polyimide film 30 having a pair of holes 31 and 32 which almost completely surround a central portion 30a of the film. Portion 30a includes a body 30a—1 which is held in place by a pair of arms 30a—2 that extend from the body 30a—1 between the holes 31 and 32 to the remaining portion 30b of the film. A plurality of electrical conductors 33 are disposed on film portion 30b and extend therefrom in a cantilevered fashion into holes 31 and 32 toward the body 30a—1. Two of those conductors which lie adjacent the arms 30a—2 also project sideways and attach to the adjacent arms, as is indicated by reference numeral 34. Body 30a—1 is shaped to cover a part of an integrated circuit chip and thereby shield it from alpha particles; and the ends of the cantilevered conductors 33 are shaped to align with terminals on the integrated circuit chip which lie outside of the covered part.

To fabricate the Figure 5 embodiment, both punching and etching steps are used. To begin, a polyimide tape having an adhesive film on one side thereof is provided; and that tape is punched to form holes 31 and 32 along with a plurality of sprocket holes 35. Thereafter, an electrically conductive film, such as one-ounce copper, is attached to the punched tape via the adhesive such that it overlies the holes 31 and 32. Subsequently, a layer of photoresist is deposited on the conductive film; the photoresist is patterned so as to cover only conductors 33; and the uncovered portion of the conductive film is etched completely through.

Next, with reference to Figure 6, still another preferred embodiment of the invention will be described. This embodiment includes a polyimide film 40 having a hole 41 which surrounds a central portion 40a of the film and separates it from the remaining portion 40b thereof. Portion has a body 40a—1 which is shaped to cover an integrated circuit and thereby shield it from alpha particles, and it has a pair of C-shaped arms 40a—2 which are joined at their ends to the body. A plurality of electrical conductors 42 lie on film portion 40b and they extend therefrom across hole 41 onto the arms 40a—2 to thereby hold film portion 40a in place. From there, the conductors 42 extend in a cantilevered fashion towards the body 40a—1 and they are shaped to align with terminals which lie next to the covered portion of the circuit. Preferably, the Figure 6 embodiment is fabricated by the same process steps that were previously described for fabricating the the Figure 3 embodiment.

Next, with reference to Figure 7, yet another preferred embodiment of the invention will be described. This embodiment includes a polyimide film 50 having four holes 51, 52, 53, and 54 which are arranged in a circular fashion to almost completely surround a central portion 50a of the film. Portion 50a includes a body 50a—1 which is shaped to cover a part of an integrated circuit and shield it from alpha particles. Also, portion 50a includes two C-shaped arms 50a—2 which connect at their ends to the body 50a—1. Further, portion 50a includes four straight arms 50a—3 which extend from the body and the C-shaped arms between the holes 51, 52, 53, and 54 to the remaining film portion 50b.

A plurality of electrical conductors 55 are disposed on film portion 50b and they extend therefrom across the holes 51, 52, 53, and 54 to the C-shaped arms 50a—2. From there, the conductors 55 extend in a cantilevered fashion towards the body 50a—1 such that their ends align with terminals on an integrated circuit chip. Sprocket holes 56 are also provided at the edge of the film. Preferably, this Figure 7 embodiment is fabricated by the process that was described above in conjunction with Figure 3; or alternatively, it can be fabricated by the process that was described above in conjunction with Figure 5.

## Claims

1. A structure for use in the fabrication of integrated circuits (23), comprising:
a film (20, 30, 40, 50) of material having a hole (21; 31, 32; 41; 51, 52, 53, 54) which surrounds a central portion (20a, 30a, 40a, 50a) of the film and separates it from the remaining portion (20b, 30b, 40b, 50b) thereof, said central portion including a body (20a—1, 30a—1, 40a—1, 50a—1) with arms (20a—2, 30a—2, 40a—2, 50a—2) extending therefrom;
a plurality of electrical conductors (22, 33, 42, 55) on said remaining portion (20b, 30b, 40b, 50b) of said film which extend therefrom across said hole (21; 31, 32; 41; 51, 52, 53, 54) onto said arms (20a—2, 30a—2, 40a—2, 50a—2) to hold said central portion (20a, 30a, 40a, 50a) of said film in place;
said conductors (22, 33, 42, 55) further extending from said arms (20a—2, 30a—2, 40a—2, 50a—2) in a cantilevered fashion into said hole (21; 31, 32; 41; 51, 52, 53) towards said body (20a—1, 30a—1, 40a—1, 50a—1);
said body (20a—1, 30a—1, 40a—1, 50a—1) being shaped to cover a portion of said integrated circuit (23) and thereby shield it from alpha particles, and said cantilevered conductors (22, 33, 42, 55) being arranged to align with contact pads (23a) in said circuit (23) outside of said covered portion.

2. The structure according to claim 1 wherein said arms (20a—2) are T-shaped and join said body (20a—1) at their bottom.

3. The structure according to claim 1 wherein said arms (40a—2, 50a—2) are C-shaped and join said body (40a—1, 50a—1) at their ends.

4. A structure according to claim 1 wherein said conductors (22, 33, 42, 55) and said film (20, 30, 40, 50) are joined together with no adhesive lying therebetween.

5. The structure according to claim 1 wherein said film (20, 30, 40, 50) is in the form of a tape; and said hole (21; 31, 32; 41; 51, 52, 53, 54), said central film portion (20a, 30a, 40a, 50a), and said conductors (22, 33, 42, 55) are repeated in combination multiple times along the length thereof.

6. A structure for use in the fabrication of an integrated circuit, comprising:
a film (30, 40, 50) of material having a plurality of holes (31, 32; 41; 51, 52, 53, 54) which are arranged to surround a central portion (30a, 40a, 50a) of the film and separate it from the remaining portion (30, 40b, 50b) thereof except for arms (30a—2; 40a—2; 50a—2, 50a—3) of the central portion (30a, 40a, 50a) which extend between the holes;

a plurality of electrical conductors (33, 42, 55) on said remaining film portion (30b, 40b, 50b) which extend therefrom in a cantilevered fashion into said holes (31, 32; 41; 51, 52, 53, 54) towards said central portion (30a, 40a, 50a) with at least some of said conductors (33, 42, 55) being attached to said arms (30a—2; 40a—2; 50a—2, 50a—3);

said central portion (30a, 40a, 50a) having a body (30a—1, 40a—1, 50a—1) that is shaped to cover a part of said integrated circuit (23) and thereby shield it from alpha particles, and said cantilevered conductors (33, 42, 55) being shaped to align with contact pads (23a) in said circuit (23) outside of said covered part.

7. The structure according to claim 6 wherein said arms (30a—2) are straight and that at least some conductors (33) have projections (34) that attach to said arms.

8. The structure according to claim 6 wherein at least some of said arms (40a—2, 50a—2) include a C-shaped portion that joins said body (40a—1, 50a—1) at its ends, and said conductors (42, 55) cross over and attach to said C-shaped portion.

9. The structure according to claim 6 wherein an adhesive lies between said film (30, 40, 50) and said conductors (33, 42, 55).

10. The structure according to claim 6 wherein said film (30, 40, 50) is in the form of a tape; and said holes (31, 32; 41; 51, 52, 53, 54), said central film portion (30a, 40a, 50a), and said conductors (33, 42, 55) are repeated in combination multiple times along the length thereof.

11. A structure comprising an insulating film (20, 30, 40, 50) having a hole (21; 31, 32; 41; 51, 52, 53, 54) and a plurality of conductors (22, 33, 42, 55) on said film that extend in a cantilevered fashion into said hole and terminate therein such that their ends align with the perimeter of a predetermined area within said hole, and a piece of atomic particle shielding material having a body portion (20a—1, 30a—1, 40a—1, 50a—1) which lies within said area and has arms (20a—2, 30a—2, 40a—2, 50a—2) that extend from said body portion beyond said area and attach to at least one of said conductors (22, 33, 42, 55) to hold said body portion in place.

**Patentansprüche**

1. Anordnung für die Benutzung in der Herstellung von integrierten Schaltungen (23),

gekennzeichnet durch einen Materialfilm (20, 30, 40, 50) mit einer Öffnung (21; 31, 32; 41; 51, 52, 53, 54), die einen zentralen Bereich (20a, 30a, 40a, 50a) des Films umschließt und ihn von den übrigen Bereichen (20b, 30b, 40b, 50b) trennt, welcher zentrale Bereich einen Körper (20a—1, 30a—1, 40a—1, 50a—1) mit davon abgehenden Armen (20a—2, 30a—2, 40a—2, 50a—2) enthält;

eine Mehrzahl von elektrischen Leitern (22, 33, 42, 55) auf den übrigen Bereichen (20b, 30b, 40b, 50b) des Films, die sich von diesem über die Öffnung (21; 31, 32; 41; 51, 52, 53, 54) zu den Armen (20a—2, 30a—2, 40a—2, 50a—2) erstrecken, um den Zentralbereich (20a, 30a, 40a, 50a) des Films in Position zu halten;

welche Leiter (22, 33, 42, 55) sich außerdem von den Armen (20a—2, 30a—2, 40a—2, 50a—2) in freitragender Weise in die Öffnung (21; 31, 32; 41; 51, 52, 53) und in Richtung auf den Körper (20a—1, 30a—1, 40a—1, 50a—1) erstrecken;

welcher Körper (20a—1, 30a—1, 40a—1, 50a—1) eine solche Form hat, daß er einen Teil der integrierten Schaltung (23) überdeckt und diese hierdurch gegenüber Alpha-Teilchen abschirmt, und wobei die freitragend ausgebildeten Leiter (22, 33, 42, 55) gegenüber Kontaktflächen (23a) der Schaltung (23) außerhalb des abgedeckten Bereiches ausgerichtet sind.

2. Anordnung nach Anspruch 1, dadurch gekennzeichnet, daß die Arme (20a—2) T-förmig ausgebildet und mit dem Körper (20a—1) über ihren Boden verbunden sind.

3. Anordnung nach Anspruch 1, dadurch gekennzeichnet, daß die Arme (40a—2, 50a—2) C-förmig ausgebildet und mit dem Körper (40a—1, 50a—1) über ihre Enden verbunden sind.

4. Anordnung nach Anspruch 1, dadurch gekennzeichnet, daß die Leiter (22, 33, 42, 55) und der Film (20, 30, 40, 50) ohne eine dazwischen liegende Klebeschicht miteinander verbunden sind.

5. Anordnung nach Anspruch 1, dadurch gekennzeichnet, daß der Film (20, 30, 40, 50) Bandform hat; und daß die Öffnung (21; 31, 32; 41; 51, 52, 53, 54), der zentrale Bereich (20a, 30a, 40a, 50a) des Films und die Leiter (22, 33, 42, 55) sich in Längsrichtung des Films gruppenweise mehrfach wiederholen.

6. Anordnung für die Benutzung in der Herstellung einer integrierten Schaltung, gekennzeichnet durch einen Materialfilm (30, 40, 50) mit einer Mehrzahl von Öffnungen (31, 32; 41; 51, 52, 53, 54), die so ausgebildet sind, daß sie einen zentralen Bereich (30a, 40a, 50a) des Films umschließen und ihn von den übrigen Bereichen (30, 40b, 50b), ausgenommen jedoch Armen (30a—2; 40a—2; 50a—2, 50a—3) des zentralen Bereiches (30a, 40a, 50a), die sich zwischen den Öffnungen erstrecken, trennen;

eine Mehrzahl von elektrischen Leitern (33, 42, 55) auf den übrigen Bereichen (30b, 40b, 50b) des Films, die sich davon in freitragender Weise in die Öffnungen (31, 32; 41; 51; 52, 53, 54) in Richtung des zentralen Bereiches (30a, 40a, 50a) erstrecken, wobei mindestens einige der Leiter (33, 42, 55) mit den Armen (30a—2; 40a—2; 50a—2, 50a—3) verbunden sind;

welcher zentrale Bereich (30a, 40a, 50a) einen Körper (30a—1, 40a—1, 50a—1) aufweist, der eine solche Form hat, daß er einen Teil der integrierten Schaltung (23) überdeckt und diese hierdurch gegenüber Alpha-Teilchen abschirmt, und wobei die freitragend ausgebildeten Leiter (33, 42, 55) eine mit Kontaktflächen (23a) der Schaltung (23) ausgerichtet sind und außerhalb des abgedeckten Bereiches liegen.

7. Anordnung nach Anspruch 6, dadurch gekennzeichnet, daß die Arme (30a—2) gerade sind und mindestens einige der Leiter (33) Vorsprünge (34) aufweisen, die an den Armen befestigt sind.

8. Anordnung nach Anspruch 6, dadurch gekennzeichnet, daß mindestens einige der Arme (40a—2, 50a—2) einen C-förmigen Bereich aufweisen, deren Enden mit dem Körper (40a—1, 50a—1) verbunden sind, und daß die Leiter (42, 55) den C-förmigen Bereich überbrücken und an diesem befestigt sind.

9. Anordnung nach Anspruch 6, dadurch gekennzeichnet, daß zwischen dem Film (30, 40, 50) und den Leitern eine Klebeschicht (33, 42, 55) vorgesehen ist.

10. Anordnung nach Anspruch 6, dadurch gekennzeichnet, daß der Film (30, 40, 50) Bandform hat; und daß die Öffnungen (31, 32; 41; 51, 52, 53, 54), der zentrale Bereich des Films (30a, 40a, 50a) und die Leiter (33, 42, 55) sich in Längsrichtung des Films gruppenweise mehrfach wiederholen.

11. Anordnung mit einem Isolierfilm (20, 30, 40, 50) der eine Öffnung (21; 31, 32; 41; 51, 52, 53, 54) und eine Mehrzahl von Leitern (22, 33, 42, 55) auf dem Film aufweist, die sich in freitragender Weise in die Öffnung erstrecken und in dieser derart enden, daß ihre Enden mit dem Umfang eines vorbestimmten Bereiches innerhalb der Öffnung ausgerichtet sind; und mit einem Stück Atomteilchen abschirmenden Materials, das einen Körperbereich (20a—1, 30a—1, 40a—1, 50a—1) aufweist, der innerhalb des vorbestimmten Bereiches liegt und Arme (20a—2, 30a—2, 40a—2, 50a—2) aufweist, die sich von dem Körperbereich bis in den vorbestimmten Bereich erstrecken und an mindestens einem der Leiter (22, 33, 42, 55) befestigt sind, um den Körperbereich in Position zu halten.

## Revendications

1. Structure destinée à être utilisée dans la fabrication de circuits intégrés (23), comprenant: un film (20, 30, 40, 50) de matériau comportant un trou (21; 31, 32; 41; 51, 52, 53, 54) qui entoure une partie centrale (20a, 30a, 40a, 50a) du film et la sépare de la partie restante (20b, 30b, 40b, 50b) du film, cette partie centrale comprenant un corps (20a—1, 30a—1, 40a—1, 50a—1) muni de bras (20a—2, 30a—2, 40a—2, 50a—2) partant de celui-ci; un certain nombre de conducteurs électriques (22, 33, 42, 55) placés sur la partie restante (20b, 30b, 40b, 50b) du film et partant de celle-ci pour traverse le trou (21; 31, 32; 41; 51, 52, 53, 54) et venir sur les bras (20a—2, 30a—2, 40a—2, 50a—2) pour maintenir en place la partie centrale (20a, 30a, 40a, 50a) du film; les conducteurs (22, 33, 42, 55) portant en outre des bras (20a—2, 30a—2, 40a—2, 50a—2) dans une disposition en porte-à-faux pour venir dans le trou (21; 31, 32; 41; 51, 52, 53) en direction du corps (20a—1, 30a—1, 40a—1, 50a—1); le corps (20a—1, 30a—1, 40a—1, 50a—1) étant formé de manière à recouvrir une partie du circuit intégré (23) pour le protéger ainsi contre les particules alpha, et les conducteurs en porte-à-faux (22, 33, 42, 55) étant disposés de manière à s'aligner avec des plots (23a) du circuit (23) à l'extérieur de la partie recouverte.

2. Structure selon la revendication 1, caractérisée en ce que les bras (20a—2) sont en forme de T et rejoignent le corps (20a—1) par leur partie inférieure.

3. Structure selon la revendication 1, caractérisée en ce que les bras (40a—2, 50a—2) sont en forme de C et rejoignent le corps (40a—1, 50a—1) par leurs extrémités.

4. Structure selon la revendication 1, caractérisée en ce que les conducteurs (22, 33, 42, 55) et le film (20, 30, 40, 50) sont reliés ensemble sans dépôt adhésif entre eux.

5. Structure selon la revendication 1, caractérisée en ce que le film (20, 30, 40, 50) se présente sous la forme d'une bande; et en ce que le trou (21; 31, 32; 41; 51, 52, 53, 54), la partie de film centrale (20a, 30a, 40a, 50a), et les conducteurs (22, 33, 42, 55), sont répétés, en combinaison, un nombre multiple de fois suivant la longueur de la bande.

6. Structure destinée à être utilisée dans la fabrication d'un circuit intégré, comprenant: un film (30, 40, 50) de matériau présentant un certain nombre de trous (31, 32; 41; 51, 52, 53, 54) disposés de manière à entourer une partie centrale (30a, 40a, 50a) du film et à la séparer de la partie restante (30, 40b, 50b) de celui-ci sauf pour les bras (30a—2; 40a—2; 50a—2, 50a—3) de la partie centrale (30a, 40a, 50a) s'étendant entre les trous; un certain nombre de conducteurs électriques (33, 42, 55) placés sur la partie de film restante (30b, 40b, 50b) et partant de celle-ci dans une disposition en porte-à-faux pour pénétrer dans les trous (31, 32; 41; 51, 52, 53, 54) en direction de la partie centrale (30a, 40a, 50a) avec certains au moins des conducteurs (33, 42, 55) fixés aux bras (30a—2; 40a—2; 50a—2, 50a—3); la partie centrale (30a, 40a, 50a) comportant un corps (30a—1, 40a—1, 50a—1) formé de manière à recouvrir une partie du circuit intégré (23) et à la protéger ainsi des particules alpha, et les conducteurs en porte-à-faux (33, 42, 55) étant formés de manière à s'aligner avec des plots de contact (23a) du circuit (23) à l'extérieur de la partie recouverte.

7. Structure selon la revendication 6, caractérisée en ce que les bras (30a—2) sont droits et en ce que certains au moins des conducteurs (33) comportent des projections (34) qui se fixent aux bras.

8. Structure selon la revendication 6, caractérisée en ce que certains au moins des bras (40a—2, 50a—2) comprennent une partie en forme de C qui se relie au corps (40a—1, 50a—1) par ses extrémités, et en ce que les conducteurs (42, 55) croisent cette partie en forme de C et se fixent à celle-ci.

9. Structure selon la revendication 6, caractérisée en ce qu'un adhésif est placé entre le film (30, 40, 50) et les conducteurs (33, 42, 55).

10. Structure selon la revendication 6, caractérisée en ce que le film (30, 40, 50) se présente sous la forme d'une bande; et en ce que les trous (31, 32; 41; 51, 52, 53, 54), la partie de film centrale (30a, 40a, 50a), et les conducteurs (33, 42, 55) sont répétés, en combinaison, un nombre multiple de fois suivant leur longueur.

11. Structure comprenant un film isolant (20, 30, 40, 50) muni d'un trou (21; 31, 32; 41; 51, 52, 53, 54) et d'un certain nombre de conducteurs (22, 33, 42, 55) placés sur le film et s'étendant dans une disposition en porte-à-faux pour pénétrer dans le trou et se terminer dans celui-ci de façon que leurs extrémités s'alignent avec le périmètre d'une zone prédéterminée à l'intérieur du trou, et une pièce de matériau de protection contre les particules atomiques comportant une partie de corps (20a—1, 30a—1, 40a—1, 50a—1) se situant à l'intérieur de la zone ci-dessus et comportant des bras (20a—2, 30a—2, 40a—2, 50a—2) qui partant de la partie de corps pour sortir de la zone et se fixer à l'un au moins des conducteurs (22, 33, 42, 55) de manière à maintenir en place la partie de corps.

0 102 525

FIG.1.

FIG.2A.

FIG.2B.

Prior Art

FIG.2C.

FIG.2D.

FIG.2E.

FIG.2E'.

1

## FIG.3.

## FIG.4A.

## FIG.4B.

## FIG.4C.

## FIG.4D.

FIG.5.

FIG.6.

FIG.7.